# EUROPEAN PATENT APPLICATION

(11) **EP 2 466 645 A1**
(43) Date of publication of application: **20.06.2012**
(21) Application number: 09848248.2
(22) Date of filing: 14.09.2009
(51) Int. Cl.: H01L 31/04

(54) **THIN-FILM PHOTOELECTRIC CONVERSION ELEMENT AND METHOD FOR MANUFACTURING THIN-FILM PHOTOELECTRIC CONVERSION ELEMENT**

(30) Priority: 11.08.2009 JP 2009186248
(71) Applicant: Nusola Inc., Niigata 940-0877 (JP)
(72) Inventor: BRICENO, Jose, Tokyo 140-0015 (JP)
(74) Representative: Sajda, Wolf E.
(86) International application number: PCT/JP2009/004551
(87) International publication number: WO 2011/018829

(57) **Abstract**

Provided are a thin-film photoelectric conversion device of which thickness can be reduced to several tens nanometers (nm) or below, and a method of manufacturing the thin-film photoelectric conversion device.

The thin-film photoelectric conversion device includes a metal silicide layer formed on a surface of a silicon substrate by diffusion of a first metal and silicon, a conductive thin-film layer formed on the surface of the silicon substrate in a region where the second metal thin-film layer is laminated, and a silicon diffused portion formed between the metal silicide layer and the conductive thin-film layer near the surface of the silicon substrate by diffusion of silicon nano-particles. Light is irradiated to the metal silicide layer or the conductive thin-film layer each forming a Schottky interface in a direction in which the metal silicide layer or the conductive thin-film layer is laminated on the silicon substrate, thereby generating a photo-induced current between the metal silicide layer and the conductive thin-film layer on the surface of the silicon substrate.

## Description

### Technical Field

The present invention relates to a thin-film photoelectric conversion device of the type using a thin film, and a method of manufacturing such a thin-film photoelectric conversion device. More particularly, the present invention relates to a thin-film photoelectric conversion device in which photo-carriers are generated in a device surface, and a method of manufacturing such a thin-film photoelectric conversion device.

### Background Art

In applications where thin-film photoelectric conversion devices are used as solar cells, it has been tried to reduce a device thickness for the purpose of cutting an amount of silicon used to form a power generation section. However, a silicon wafer cut from an ingot has a limitation in reducing its thickness down to about 150 µm.
Also, because a thinner film invites insufficient absorption of light and reduces photoelectric conversion efficiency, an antireflection film or the like is formed to compensate for the reduction of the photoelectric conversion efficiency. Thus, there has been a limitation in reducing the total device thickness.

In view of such a situation, a thin-film silicon solar cell is proposed in which a thin film of amorphous silicon (hereinafter referred to as "a-Si") or microcrystalline silicon is formed by the CVD process, for example, and a cell thickness is reduced to about 1% of the thickness of a general silicon solar cell. Fig. 8 is a sectional view of a thin-film silicon solar cell 100 (Patent Literature 1) which employs an a-Si film and has a PIN structure. The thin-film silicon solar cell 100 is formed on a glass substrate 101.

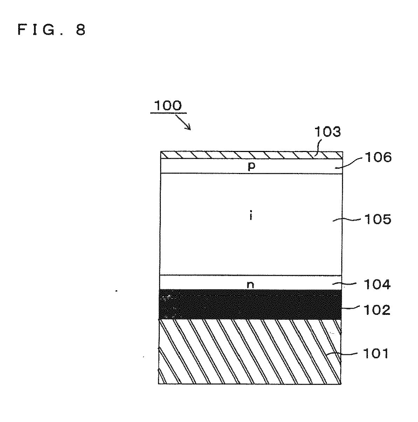

In the thin-film silicon solar cell 100, as illustrated in Fig. 8, an n-layer 104 made of an a-Si film, an i-layer 105 made of a semi-crystallized a-Si film, and a p-layer 106 made of an a-Si film, these three films constituting a PIN structure, are successively layered one above another between a lower electrode 102 made of silver and a transparent upper electrode 103 made of indium tin oxide (ITO). Here, respective thicknesses of those layers and electrodes are set such that the lower electrode 102 is about 100 nm, the upper electrode 103 is about 70 nm, the n-layer 104 is about 50 nm, the i-layer 105 is about 2 µm, and the p-layer 106 is about 20 nm.

The i-layer 105 has the power generation function of producing carriers due to the photoelectric effect by receiving light that has passed through the transparent upper electrode 103 at the top. Each of the n-layer 104 and the p-layer 106 has the function of separating the carriers produced in the i-layer 105 by applying an internal electric field to the layer 105.

Accordingly, when light is irradiated to the thin-film silicon solar cell 100 from above, the carriers produced by receiving the light and separated in the i-layer 105 drift to the n-layer 104 or the p-layer 106, i.e., in the direction in which the layers are laminated (formed one above another). By short-circuiting between the lower electrode 102 and the upper electrode 103, therefore, a photo-induced current flows due to the drift of the carriers between the lower electrode 102 and the upper electrode 103 in the direction in which the layers are laminated.

### Citation List

### Patent Literature

- PTL 1:: Japanese Unexamined Patent Application Publication JP-A-2000-349 321

### Summary of Invention

### Technical Problem

However, even the thin-film silicon solar cell 100 having a thickness reduced by forming the silicon thin film still has a limitation in reducing the thickness for the following reasons. Because power is generated by producing the photo-carriers that flow through the PIN structure in the incident direction of light, i.e., in the direction in which the layers are laminated, there is a minimum limit of the thickness of the PIN structure at about 1 µm even in the case of using the a-Si with a high absorption coefficient. Also, the upper electrode 103 and the lower electrode 102 need to be disposed at opposite sides of the PIN structure, respectively, in order to take out the photo-induced current flowing in the direction in which the layers are laminated.

Further, in order to cause the incident light to reach the i-layer 105 that has the power generation function, the upper electrode 103 covering an entire upper surface of the i-layer 105 needs to be made of a transparent conductive material, such as ITO. Still further, since the thin film cannot absorb the incident light in sufficient amount if the thin film is used in its state just after being formed, a structure for increasing utilization efficiency of the incident light is employed, for example, by texturing the film surface so as to control optical characteristics.

In addition, the a-Si has a large forbidden band width. More specifically, the a-Si is responsive to light having comparatively short wavelengths of not longer than 700 nm, but it cannot utilize light having comparatively long wavelengths, e.g., infrared rays. Taking into account such a property, a tandem structure added with a microcrystalline silicon layer is proposed.
Another proposal is, as disclosed in Patent Literature 1, to provide a structure that a crystal fraction of amorphous and microcrystalline silicon in the i-layer 105 is changed in the direction in which the layers are laminated, thus causing the i-layer 105 to be responsive to a wider band of light. For those reasons, a complicated process has been required.

The present invention has been accomplished in consideration of the above-mentioned problems with the prior art, and an object of the present invention is to provide a thin-film photoelectric conversion device of which thickness can be reduced to several tens nanometers (nm) or below, and a method of manufacturing the thin-film photoelectric conversion device.

Another object of the present invention is to provide a thin-film photoelectric conversion device of which thickness can be further reduced by arranging a pair of electrodes to lead out a photo-induced current on the same surface, and a method of manufacturing the thin-film photoelectric conversion device.

Still another object of the present invention is to provide a thin-film photoelectric conversion device in which a silicon layer has a thickness of 20 nm or below and an amount of used silicon materials can be reduced to realize cost-cutting, and a method of manufacturing the thin-film photoelectric conversion device.

Still another object of the present invention is to provide a thin-film photoelectric conversion device which is formed to be responsive to a wide band of light from a visible range to an infrared range by a simple annealing step without requiring a complicated and precise semiconductor control process, and a method of manufacturing the thin-film photoelectric conversion device.

### Solution to Problem

To achieve the above objects, the invention defined in Claim 1 resides in a thin-film photoelectric conversion device being subjected to annealing of a silicon substrate on which a first metal thin-film layer made of a first metal and a second metal thin-film layer made of a second metal are laminated such that the second metal thin-film layer overlaps with a part of the first metal thin-film layer, the thin-film photoelectric conversion device comprising a metal silicide layer formed on a surface of the silicon substrate by diffusion of the first metal and silicon, a conductive thin-film layer formed on the surface of the silicon substrate in a region where the second metal thin-film layer is laminated, and a silicon diffused portion formed between the metal silicide layer and the conductive thin-film layer near the surface of the silicon substrate by diffusion of silicon nano-particles, wherein light is irradiated to the metal silicide layer or the conductive thin-film layer each forming a Schottky interface in a direction in which the metal silicide layer or the conductive thin-film layer is laminated on the silicon substrate, thereby generating a photo-induced current between the metal silicide layer and the conductive thin-film layer on the surface of the silicon substrate.

With the effect of the annealing, respective nano-particles of the first metal, the second metal, and silicon are caused to mutually diffuse in the conductive thin-film layer, while respective nano-particles of the first metal and silicon are caused to mutually diffuse in the metal silicide layer. Those diffusions give rise to a phenomenon that activation energy of each element is increased at a maximum depth of 20 nm or below and a bulk-dependent property disappears in terms of a state chart.

Along the surface of the silicon substrate, the Schottky interface is formed between the silicon diffused portion and the metal silicide layer and between the silicon diffused portion and the conductive thin-film layer. It is, however, deemed that, in the region where the conductive thin-film layer is formed, a metal-rich region is formed and change to the ohmic state is progressed because the second metal thin-film layer is laminated on the first metal thin-film layer and the relevant region has a larger thickness than the first metal thin-film layer forming metal silicide, and that the pinning action of a barrier is weakened to reduce the height of the barrier between the silicon diffused portion and the conductive thin-film layer. As a result, the Schottky barrier between the silicon diffused portion and the metal silicide layer forms a diode of which forward direction is defined as a direction toward the conductive thin-film layer from the metal silicide layer.

When light is irradiated to the conductive thin-film layer forming the Schottky interface in the direction in which the conductive thin-film layer is laminated on the silicon substrate, a large number of photo-carriers are induced in the conductive thin-film layer and are caused to drift along the surface of the silicon substrate based on a forward bias characteristic that is provided by the above-mentioned diode along the surface of the silicon substrate. As a result, a photo-induced current flows along the substrate surface.

Similarly, when light is irradiated to the metal silicide layer forming the Schottky interface in the direction in which the metal silicide layer is laminated on the silicon substrate, a large number of photo-carriers are induced in the metal silicide layer and are caused to drift along the surface of the silicon substrate based on the forward bias characteristic that is provided by the above-mentioned diode along the surface of the silicon substrate. As a result, a photo-induced current flows along the surface of the silicon substrate.

Since the metal silicide layer and the conductive thin-film layer formed on the surface of the silicon substrate have conductivity, a conduction loss of the photo-carriers induced on the substrate surface is suppressed.

In the metal silicide layer and the conductive thin-film layer where the silicon nano-particles coexist, because the silicon particles have nano-sizes, the wavenumber selection rule depends on direct transition instead of the bulk, and an inter-band excitation occurs which corresponds to an energy gap from the Si valence band to a visible range. As a result, in the conductive thin-film layer, photo-carriers are generated not only upon irradiation of light primarily having long wavelengths in the infrared range due to the Schottky interface as viewed in the direction in which the layers are laminated, but also upon irradiation of light primarily having short wavelengths in the visible range due to excitation of the silicon nano-particles. Because both the types of photo-carriers are generated in an added manner, response sensitivity can be increased and a wide-band response characteristic ranging from visible light to infrared rays can be obtained.

According to the invention defined in Claim 2, the conductive thin-film layer has a thickness of smaller than 100 nm and the metal silicide layer has a smaller thickness than the conductive thin-film layer.

Amounts of the first metal and the second metal used as respective materials of the metal silicide layer and the conductive thin-film layer can be greatly cut. Further, the conductive thin-film layer and the metal silicide layer can be formed on the silicon substrate by simple steps of vapor-depositing the respective materials on the silicon substrate and annealing them.

According to the invention defined in Claim 3, the first metal is any of Co, Fe, W, Ni, Al and Ti, and the second metal is Au.

Co, Fe, W, Ni, Al and Ti have high melting points and are superior in mechanical properties at high temperatures. Hence, those elements are suitable as the materials of the metal silicide layer. Also, Au serves to aid diffusion of the respective nano-particles of the first metal and silicon in a region around Au, thus facilitating formation of the silicon diffused portion between the metal silicide layer and the conductive thin-film layer.

Further, the invention defined in Claim 4 resides in a method of manufacturing a thin-film photoelectric conversion device, the method comprising a first step of forming a first metal thin-film layer made of a first metal on a silicon substrate, a second step of forming a second metal thin-film layer made of a second metal on a part of the first metal thin-film layer, and a third step of annealing the first metal thin-film layer and the second metal thin-film layer which are laminated on the silicon substrate, to thereby form a metal silicide layer on the substrate, the metal silicide layer containing the first metal and silicon diffused therein, a conductive thin-film layer in a region where the second metal thin-film layer is laminated, and a silicon diffused portion between the metal silicide layer and the conductive thin-film layer near the surface of the silicon substrate, the conductive thin-film layer containing silicon nano-particles diffused therein, wherein light is irradiated to the metal silicide layer or the conductive thin-film layer each forming a Schottky interface in a direction in which the metal silicide layer or the conductive thin-film layer is laminated on the silicon substrate, thereby generating a photo-induced current between the metal silicide layer and the conductive thin-film layer on the surface of the silicon substrate.

With the effect of the annealing, respective nano-particles of the first metal, the second metal, and silicon are caused to mutually diffuse in the conductive thin-film layer, while respective nano-particles of the first metal and silicon are caused to mutually diffuse in the metal silicide layer. Those diffusions give rise to a phenomenon that activation energy of each element is increased at a maximum depth of 20 nm or below and a bulk-dependent property disappears in terms of a state chart.

Along the surface of the silicon substrate, the Schottky interface is formed between the silicon diffused portion and the metal silicide layer and between the silicon diffused portion and the conductive thin-film layer. It is, however, deemed that, in the region where the conductive thin-film layer is formed, a metal-rich region is formed and change to the ohmic state is progressed because the second metal thin-film layer is laminated on the first metal thin-film layer and the relevant region has a larger thickness than the first metal thin-film layer forming metal silicide, and that the pinning action of a barrier is weakened to reduce the height of the barrier between the silicon diffused portion and the conductive thin-film layer. As a result, the Schottky barrier between the silicon diffused portion and the metal silicide layer forms a diode of which forward direction is defined as a direction toward the conductive thin-film layer from the metal silicide layer.

When light is irradiated to the conductive thin-film layer forming the Schottky interface in the direction in which the conductive thin-film layer is laminated on the silicon substrate, a large number of photo-carriers are induced in the conductive thin-film layer and are caused to drift along the surface of the silicon substrate based on a forward bias characteristic that is provided by the above-mentioned diode along the surface of the silicon substrate. As a result, a photo-induced current flows along the substrate surface.

Similarly, when light is irradiated to the metal silicide layer forming the Schottky interface in the direction in which the metal silicide layer is laminated on the silicon substrate, a large number of photo-carriers are induced in the metal silicide layer and are caused to drift along the surface of the silicon substrate based on the forward bias characteristic that is provided by the above-mentioned diode along the surface of the silicon substrate. As a result, a photo-induced current flows along the surface of the silicon substrate.

Since the metal silicide layer and the conductive thin-film layer formed on the surface of the silicon substrate have conductivity, a conduction loss of the photo-carriers induced on the substrate surface is suppressed.

In the metal silicide layer and the conductive thin-film layer where the silicon nano-particles coexist, because the silicon particles have nano-sizes, the wavenumber selection rule depends on direct transition instead of the bulk, and an inter-band excitation occurs which corresponds to an energy gap from the Si valence band to a visible range. As a result, in the conductive thin-film layer, photo-carriers are generated not only upon irradiation of light primarily having long wavelengths in the infrared range due to the Schottky interface as viewed in the direction in which the layers are laminated, but also upon irradiation of light primarily having short wavelengths in the visible range due to excitation of the silicon nano-particles. Because both the types of photo-carriers are generated in an added manner, response sensitivity can be increased and a wide-band response characteristic ranging from visible light to infrared rays can be obtained.

According to the invention defined in Claim 5, the conductive thin-film layer has a thickness of smaller than 100 nm and the metal silicide layer has a smaller thickness than the conductive thin-film layer.

Amounts of the first metal and the second metal used as respective materials of the metal silicide layer and the conductive thin-film layer can be greatly cut. Further, the conductive thin-film layer and the metal silicide layer can be formed on the silicon substrate by simple steps of vapor-depositing the respective materials on the silicon substrate and annealing them.

According to the invention defined in Claim 6, the first metal is any of Co, Fe, W, Ni, Al and Ti, and the second metal is Au.

Co, Fe, W, Ni, Al and Ti have high melting points and are superior in mechanical properties at high temperatures. Hence, those elements are suitable as the materials of the metal silicide layer. Also, Au serves to aid diffusion of the respective nano-particles of the first metal and silicon in a region around Au, thus facilitating formation of the silicon diffused portion between the metal silicide layer and the conductive thin-film layer.

### Advantageous Effects of Invention

According to the inventions defined in Claims 1 and 4, since the photoelectric conversion is performed in a surface layer of the silicon substrate without utilizing light that passes through the silicon substrate, the photo-induced current can be obtained with a smaller light loss and higher sensitivity.

Also, since the photo-carriers drift along the substrate surface, high-speed photo-induced carriers are generated at a drift speed of about 10⁷ cm/s, which corresponds to a speed level in compound semiconductors. Accordingly, when the inventions are applied to a light detection sensor, an ultra high-speed imaging sensor and a photoelectric conversion device, which is responsive to optically modulated waves in bands on the orders of GHz to THz, can be realized. Because of the type using the thin-film, the photoelectric conversion device according to the invention can also be used as surface-detection CCD sensors which can be constituted in an arrayed form.

Further, the photo-induced current can be generated in response to light in a wide wavelength band from the visible range to the infrared range without depending on the height of the Schottky barrier with respect to silicon. Accordingly, when the inventions are applied to a light detection sensor, light over a wide band can be detected with a superior sensitivity characteristic.
Also, when the inventions are applied to a solar cell, sunlight over a wide band can be utilized to generate electric power through the photoelectric conversion. In a cloudy day, particularly, the thin-film photoelectric conversion device according to the invention can utilize solar energy for conversion to electric power in amount about twice that capable being converted by a solar cell using a Si-based photoelectric conversion device with a p-n junction.
In addition, it is expected that the thin-film photoelectric conversion device according to the invention can generate electric power day and night by performing the photoelectric conversion of infrared rays which are scattered into the atmosphere after sunset. Since the scattered infrared rays are converted to electric power before being converted to heat, the thin-film photoelectric conversion device according to the invention can be further expected as means for preventing global warming.

The thickness of the thin-film photoelectric conversion device according to the invention can be made much smaller than that of a photoelectric conversion device with a pn-junction or a thin-film photoelectric conversion device of which thickness is reduced by forming a silicon thin film. Moreover, the thin-film photoelectric conversion device according to the invention can be manufactured by using very small amounts of rare elements, such as the first metal, the second metal, and silicon.

Since the photo-induced current or the photo-induced voltage can be taken out from a pair of electrodes connected respectively to the metal silicide layer and the conductive thin-film layer which are present on the same surface side of the silicon substrate, the thickness of the thin-film photoelectric conversion device can be further reduced because of no necessity of arranging the pair of lead-out electrodes separately in opposite sides of the device in the direction in which the layers are laminated.

According to the invention defined in Claim 4, the thin-film photoelectric conversion device can be produced by a simple manufacturing process of annealing the silicon substrate including the first metal thin-film layer which is laminated on the substrate surface and the second metal thin-film layer which is further laminated on a part of the first metal thin-film layer, and the manufacturing process can be practiced by utilizing a Si-base process used to form the metal silicide.

According to the inventions defined in Claims 2 and 5, the photo-induced current is generated by using the conductive thin-film layer with a thickness smaller than 100 nm and the metal silicide layer having a smaller thickness than the conductive thin-film layer, both the layers constituting the surface layer of the silicon substrate. Therefore, the thickness of the thin-film photoelectric conversion device can be further reduced.
When the thin-film photoelectric conversion device is used as a solar cell, it can be bonded to, e.g., wall surfaces of buildings and cars, and casings of various portable devices, such as cell phones. In other words, the thin-film photoelectric conversion device has no limitations in its mounting place.

According to the inventions defined in Claims 3 and 6, since the first metal and the second metal, the latter being a precious metal, are used only to form the metal silicide layer and the conductive thin-film layer, respectively, the thin-film photoelectric conversion device can be manufactured by using very small amounts of rare elements.

The first metal has a high melting point and is superior in mechanical properties at high temperatures. Hence, the first metal is suitable as the material of the metal silicide. In particular, when the first metal is Co, the metal silicide is formed as CoSix that is employed to form undercoats of electrodes in silicon devices. Hence, the existing process can be utilized in manufacturing the thin-film photoelectric conversion device.

### Brief Description of Drawings

- Fig. 1: is a vertical sectional view of a thin-film photoelectric conversion device 1 according to one embodiment of the present invention.
- Fig. 2: is an equivalent circuit diagram of the thin-film photoelectric conversion device 1.
- Fig. 3: illustrates successive steps of a manufacturing process for the thin-film photoelectric conversion device 1.
- Fig. 4: is a graph of I-V curves illustrating the relationships of a bias voltage V applied between electrodes 4 and 5 of the thin-film photoelectric conversion device 1 versus currents I_{b}, I_{b1} and I_{b2} flowing between the electrodes 4 and 5.
- Fig. 5: is a graph of I-V curves plotting a photo-induced current I₁ flowing between the electrodes 4 and 5 when light is irradiated to a metal silicide layer 3 and a photo-induced current I₂ flowing between the electrodes 4 and 5 when light is irradiated to a conductive thin-film layer 9, with respect to the bias voltage V.
- Fig. 6: is an energy diagram illustrating drift of photo-carriers induced upon irradiation of light to the metal silicide layer 3.
- Fig. 7: is an energy diagram illustrating drift of photo-carriers induced upon irradiation of light to the conductive thin-film layer 9.
- Fig. 8: is a sectional view of a thin-film silicon solar cell 100 of prior art.

### Description of Embodiments

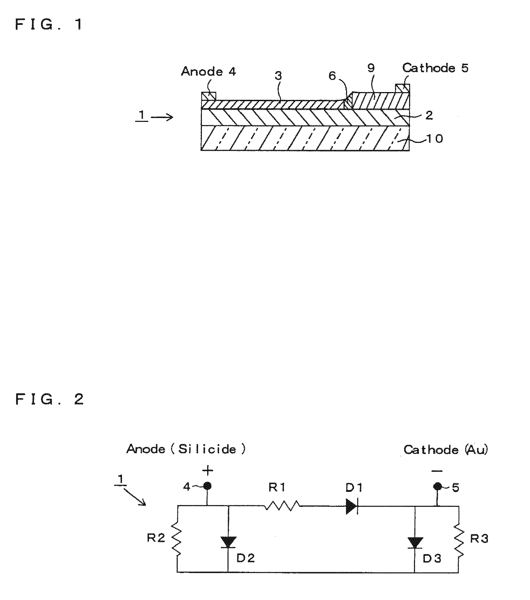

A thin-film photoelectric conversion device 1 and a method of manufacturing the same, according to one embodiment of the present invention, will be described below with reference to Figs. 1 to 7.
The thin-film photoelectric conversion device 1 according to the embodiment includes, as illustrated in Fig. 1, an n-Si substrate 2 which is a semiconductor substrate and is made of n-type Si, a CoSix layer 3 which is a metal silicide layer self-assembled on the surface of the n-Si substrate 2, an anode 4 which is ohmic-connected to a part of the CoSix layer 3, a conductive thin-film layer 9 which is formed on the surface of the n-Si substrate 2, a cathode 5 which is ohmic-connected to a part of the conductive thin-film layer 9, and a silicon diffused portion 6 which is positioned between the CoSix layer 3 and the conductive thin-film layer 9 and which contains silicon nano-particles diffused in the surface thereof.
In the illustrated embodiment, the thin-film photoelectric conversion device 1 is bonded to a glass plate 10, which serves as a window pane, in view of the application where the thin-film photoelectric conversion device 1 is used as a solar cell. Thus, a pair of the anode 4 and the cathode 5 for taking out a photo-induced current to the exterior are formed on the same surface of the n-Si substrate 2.

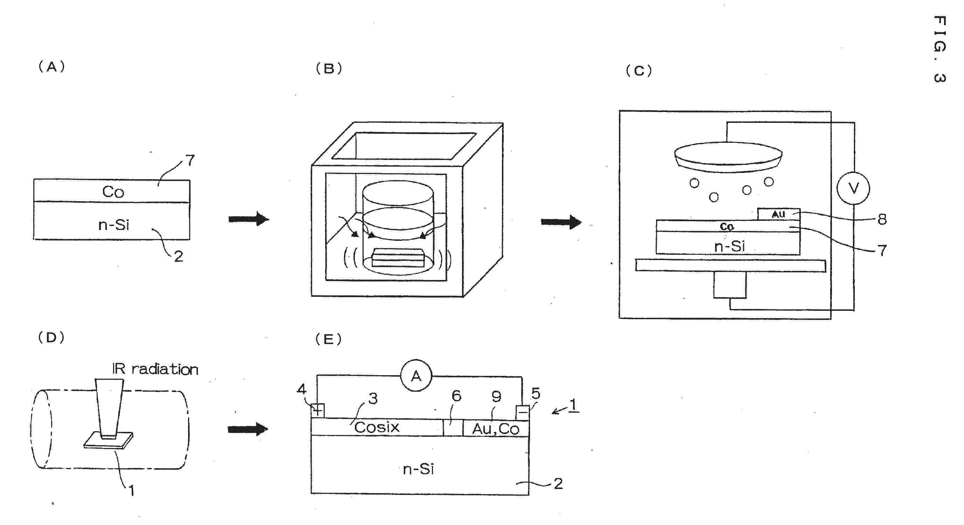

The thin-film photoelectric conversion device 1 having the above-described structure is obtained through successive steps of a manufacturing process illustrated in Fig. 3. A Co thin film 7 having a thickness of 8 nm is formed (see (A)) by sputtering on the n-Si substrate 2, which has a substantially square shape and which is made of n-type Si. After organic cleaning for 5 minutes (see (B)), a mask is printed on the square Co thin film 7 and an Au thin film 8 having a thickness of about 10 nm is formed (see (C)) by sputtering to form the conductive thin-film layer 9 on a partial region of the square Co thin film 7.
Thereafter, the thin-film photoelectric conversion device 1 is heated to temperature in the range of 400 °C to 800 °C, preferably to 600 °C, in a temperature rise time of 3 minutes for annealing at the temperature of 600 °C for 3 minutes (see (D)). Further, the anode 4 and the cathode 5 are ohmic-connected (see (E)) to the CoSix layer 3 and the conductive thin-film layer 9, respectively, which are formed on the n-Si substrate 2. As a result, the thin-film photoelectric conversion device 1 is manufactured.

In the thin-film photoelectric conversion device 1 manufactured through the above-described process, Si, Co and Au in the multilayer state are caused to mutually diffuse by the annealing. In the region where only the Co thin film 7 is formed, therefore, the self-assembled CoSix layer 3 is formed on the surface of the Si substrate 2. Also, in the region where the Au thin film 8 is further formed on the Co thin film 7, the conductive thin-film layer 9 is formed in which respective nano-particles of Co, Au and Si are diffused so as to provide a state of Co and Au being rich.

In the region where the CoSix layer 3 and the conductive thin-film layer 9 are formed by the annealing, the Schottky interface is formed between the n-Si substrate 2 and each of the CoSix layer 3 and the conductive thin-film layer 9 as viewed in the direction in which the layers are laminated. In the region where the conductive thin-film layer 9 is formed, the Schottky interface is formed between CoSix and Si or between Au and Si. In addition, the regions where the diffusion has been further progressed by the annealing are formed as regions which are ohmic-connected to the n-Si substrate 2.
Accordingly, an equivalent circuit is formed as illustrated in Fig. 2. More specifically, in the regions where the Schottky interface is formed, diodes D2 and D3 are formed with the forward direction being oriented from the CoSix layer 3 and the conductive thin-film layer 9 toward the n-Si substrate 2 as viewed in the direction in which the layers are laminated. Further, in the regions ohmic-connected to the n-Si substrate 2, resistances R2 and R3 are connected in parallel to the diodes D2 and D3, respectively.

With the effect of the annealing, respective nano-particles of Co, Au and Si are caused to mutually diffuse in the conductive thin-film layer 9, while respective nano-particles of Co and Si are caused to mutually diffuse in the CoSix layer 3. Those diffusions give rise to a phenomenon that activation energy of each element is increased at a maximum depth of 20 nm or below and a bulk-dependent property disappears in terms of a state chart.
Further, in the CoSix layer 3 and the conductive thin-film layer 9 where the nano-particles of Si coexist, because the Si particles have nano-sizes, the wavenumber selection rule depends on direct transition instead of the bulk, and an inter-band excitation occurs which corresponds to an energy gap from the Si valence band to a visible range.
As a result, in the CoSix layer 3 and the conductive thin-film layer 9, photo-carriers are generated not only upon irradiation of light having long wavelengths in the infrared range due to the Schottky interface as viewed in the direction in which the layers are laminated, but also upon irradiation of light having short wavelengths in the visible range due to excitation of the silicon nano-particles.
Thus, because the thin-film photoelectric conversion device 1 is responsive to both the types of photo-carriers, response sensitivity can be increased and a wide-band response characteristic ranging from visible light to infrared rays can be obtained.

Simultaneously, with the effect of the annealing, the Si nano-particles in the n-Si substrate 2 are more apt to diffuse toward the substrate surface and thereabout with the aid of Au around the Au thin film 8, whereby a silicon diffused portion 6 containing a large number of silicon nano-particles diffused therein along with CoSix, Au and Co is formed between the CoSix layer 3 and the conductive thin-film layer 9.
In this embodiment, the silicon diffused portion 6 is formed at a width within 1 mm at maximum from the periphery of the Au thin film 8. Theoretically, the Schottky interface is further formed between the silicon diffused portion 6 made of the semiconductor and the conductive thin-film layer 9 and between the silicon diffused portion 6 and the CoSix layer 3 in the horizontal direction along the surface of the n-Si substrate 2.
It is, however, deemed that, in a region closer to the conductive thin-film layer 9 where the Au thin film 8 is laminated on the Co thin film 7, the metal is richer and change to the ohmic state is more progressed than in a region closer to the CoSix layer 3 where only the Co thin film 7 is present prior to the annealing, and that the pinning action of a barrier is weakened to reduce the height of the barrier between the silicon diffused portion 6 and the conductive thin-film layer 9. As a result, the Schottky interface between the silicon diffused portion 6 and the CoSix layer 3 forms a diode D1 of which forward direction is defined as a horizontal direction toward the conductive thin-film layer 9 from the CoSix layer 3.

Accordingly, the thin-film photoelectric conversion device 1 after being subjected to the annealing has a circuit configuration illustrated as an equivalent circuit diagram in Fig. 2. Be it noted herein that the illustrated equivalent circuit is formed by the CoSix layer 3, the silicon diffused portion 6, and the conductive thin-film layer 9, which are each present in a thin film having a thickness within 20 nm, as well as by a very shallow surface layer of the n-Si substrate 2. A resistance R1 represents the resistance of the CoSix layer 3 between the anode 4 and the cathode 5.

A measurement has been conducted to confirm that, when light is irradiated to the surface side (i.e., the upper side as viewed in Fig. 1) of the thin-film photoelectric conversion device 1 having the above-described structure, photo-induced currents I₁ and I₂ are generated between the anode 4 and the cathode 5 both of which are formed on the same side as the light receiving surface of the thin-film photoelectric conversion device 1.
In the measurement, an excitation laser beam with a wavelength of 632 nm, an output of 1.68 mW, and an irradiation area of 0.4 /mm² is irradiated to the CoSix layer 3 and the conductive thin-film layer 9 while a bias voltage Vb between the anode 4 and the cathode 5 is changed, and the photo-induced currents are compared with a current Ib flowing between the anode 4 and the cathode 5 when the excitation laser beam is not irradiated.

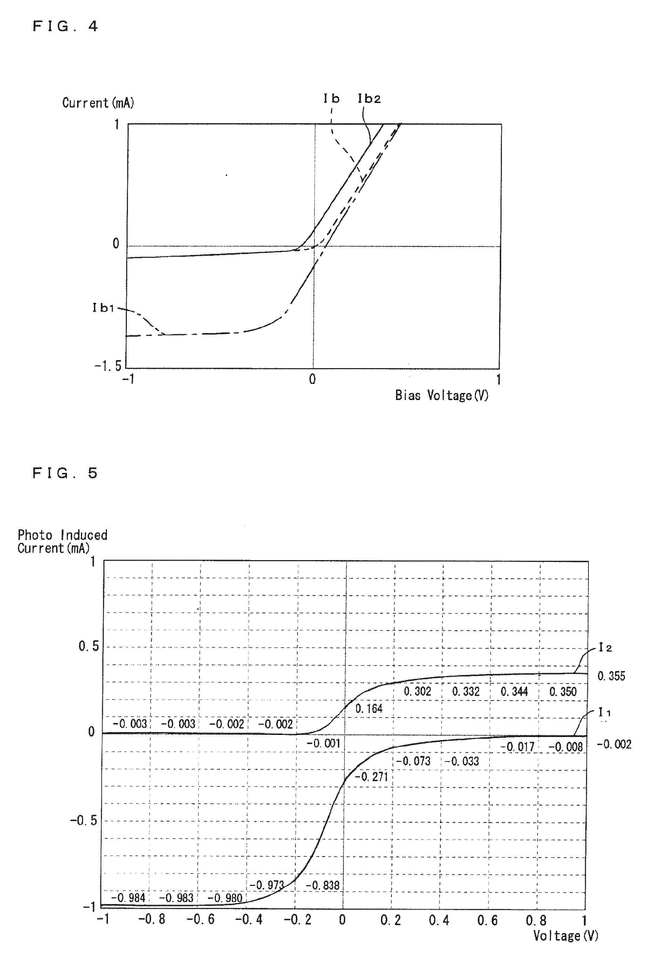

Fig. 4 is a graph of I-V curves illustrating the relationships of currents I_{b}, I_{b1} and I_{b2} generated between the anode 4 and the cathode 5 under respective measurement conditions versus the bias voltage V between both the electrodes. In Fig. 4, I_{b} indicated by a broken line represents a value of the current flowing between the anode 4 and the cathode 5 when the excitation laser beam is not irradiated, I_{b1} represents a value of the current generated upon irradiation of the excitation laser beam to the CoSix layer 3, and I_{b2} represents a value of the current generated upon irradiation of the excitation laser beam to the conductive thin-film layer 9.

The diode D1 of which forward direction is defined as the direction toward the conductive thin-film layer 9 from the CoSix layer 3 is confirmed from such a waveform of the current I_{b} that the current is substantially 0 at negative bias voltages and rises as a positive bias voltage increases. Judging from the I-V curve graph, the height of the Schottky barrier is estimated to be in the range of 0.56 eV to 0.58 eV.

Fig. 5 is a graph of I-V curves representing, based on the measured results illustrated in Fig. 4, photo-induced currents I₁ and I₂ generated by only the irradiation of the excitation laser beam, i.e., except for the current I_{b} which flows between the anode 4 and the cathode 5 with the application of the bias voltage, with respect to the bias voltage Vb.
Specifically, I₁ in Fig. 5 represents a current value calculated as I_{b1} - I_{b}, and I₂ represents a current value calculated as I_{b2} - I_{b}. Each numerical value (unit: mA) in Fig. 5 represents a current value denoted by the vertical axis on the left side when the bias voltage Vb is applied.

As plotted in Fig. 5, the value of the photo-induced current I₁ generated upon the irradiation of the excitation laser beam to the CoSix layer 3 is substantially zero while the positive bias voltage Vb is applied. When the negative bias voltage Vb is applied, the photo-induced current I₁ of about -0.98 mA is generated to flow toward the anode 4 from the cathode 5.

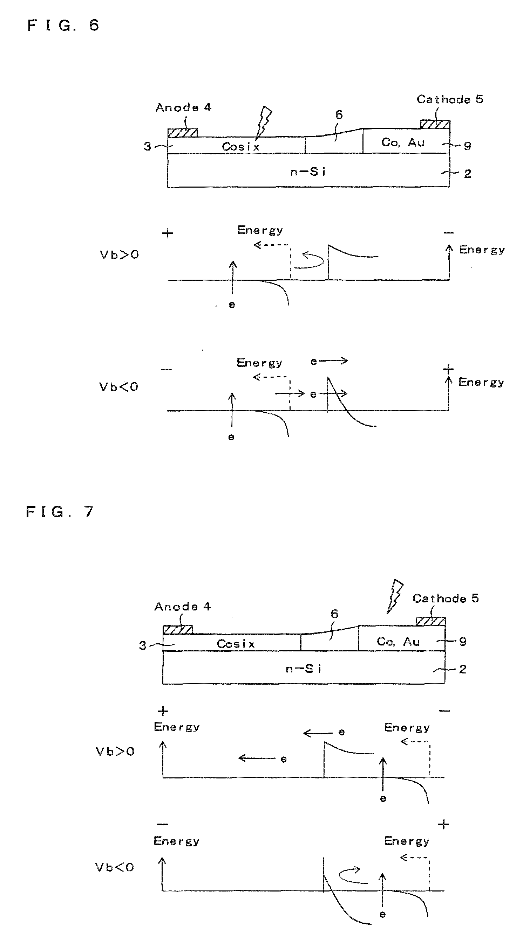

As illustrated in Fig. 6, in the state where the positive bias voltage Vb is applied, photo-carriers (photo-induced electrons) induced from the n-Si substrate 2 under the CoSix layer 3 by receiving the light behave such that drift of the photo-carriers toward the cathode 5 is blocked by the Schottky barrier present in a way toward the cathode 5 and the photo-carriers are attracted in a direction toward the anode 4 at a (+)-side potential so as to recombine with positive holes in the underlying n-Si substrate 2 through the resistance R2.
Accordingly, the induced photo-carriers do not appear as the current I₁ flowing between the anode 4 and the cathode 5. On the other hand, in the state where the negative bias voltage Vb is applied, the photo-carriers (photo-induced electrons) induced into the CoSix layer 3 from the n-Si substrate 2 are attracted in a direction toward the cathode 5 at a (+)-side potential even though a reverse bias is applied to the diode D1.
After passing through the diode D1 by bypassing it or with the aid of the tunnel effect, the photo-carriers flow through the conductive thin-film layer 9 up to the cathode 5 and recombine with positive holes in the underlying n-Si substrate 2 through the anode 4 and the resistance R2. Accordingly, the negative photo-induced current I₁ flows along the surface of the thin-film photoelectric conversion device 1.

Further, as plotted in Fig. 5, the photo-induced current I₂ generated upon the irradiation of the excitation laser beam to the conductive thin-film layer 9 flows, when the positive bias voltage Vb is applied, at a value of about 0.35 mA in the positive direction toward the cathode 5 from the anode 4. While the negative bias voltage Vb is applied, the photo-induced current I₂ does not flow, namely the current value is substantially zero.

As illustrated in Fig. 7, in the state where the positive bias voltage Vb is applied, photo-carriers (photo-induced electrons) induced from the n-Si substrate 2 under the conductive thin-film layer 9 by receiving the light are attracted in a direction toward the anode 4 at a (+)-side potential. Because a forward bias is applied to the diode D1, the photo-carriers pass through the diode D1 and then flow through the conductive CoSix layer 3 up to the anode 4 so as to recombine with positive holes in the underlying n-Si substrate 2 through the cathode 5 and the resistance R3.
Accordingly, the positive photo-induced current I₂ flows along the surface of the thin-film photoelectric conversion device 1. On the other hand, in the state where the negative bias voltage Vb is applied, the photo-carriers (photo-induced electrons) induced from the n-Si substrate 2 into the conductive thin-film layer 9 are blocked from drifting in a direction toward the anode 4 by the barrier of the diode D1 to which a reverse bias is applied, and are attracted in a direction toward the cathode 5 at a (+)-side potential so as to recombine with positive holes in the underlying n-Si substrate 2 through the resistance R3. Accordingly, the induced photo-carriers do not appear as the current I₂ flowing between the anode 4 and the cathode 5.

The above-described photo-induced currents I₁ and I₂ flow primarily in a surface conductive layer, having a thickness of 20 nm or below, on the n-Si substrate 2 and the Schottky operated by a large number of carriers is utilized. For those reasons, the carriers can drift at high speed and a high-speed response can be obtained which corresponds to a response level of a HEMT (High Electron Mobility Transistor) in which carriers drift in the planar direction. Therefore, the thin-film photoelectric conversion device 1 can be used in photosensors for bands on the orders of GHz to THz.

Also, it is proved that the thin-film photoelectric conversion device 1 according to this embodiment is responsive to light ranging from a visible range to an infrared range (0.4 µm to 2 µm). Thus, when the thin-film photoelectric conversion device 1 is used as a solar cell, the device 1 can perform the photoelectric conversion of lights covering from visible light to infrared rays with higher conversion efficiency.
Moreover, since the thin-film photoelectric conversion device 1 is obtained in the form of a very thin flexible film, it can be bonded to wall surfaces of buildings and case surfaces of various portable devices. In other words, the thin-film photoelectric conversion device 1 has no limitations in its mounting space.

Further, since the CoSix layer 3, the silicon diffused portion 6, and the conductive thin-film layer 9 are just formed on the n-Si substrate 2 as described above in the embodiment, the thin-film photoelectric conversion device suitably used for a solar cell, an image sensor, etc. can be manufactured with a simple Si-based process.

The Co thin film 7 formed on the n-Si substrate 2 to constitute the CoSix layer 3 may be a thin-film metal layer made of Fe, W, Ni, Al or Ti, for example, and the silicon substrate 2 may be a p-Si substrate.

### Industrial Applicability

The present invention is suitably implemented as the thin-film photoelectric conversion device for use in solar cells and high-speed photosensors.

### List of Reference Signs

- 1: = thin-film photoelectric conversion device
- 2: = n-Si substrate (silicon substrate)
- 3: = CoSix layer (metal silicide layer)
- 4: = anode
- 5: = cathode
- 6: = silicon diffused portion
- 7: = Co thin film (first metal thin-film layer)
- 8: = Au thin film (second metal thin-film layer)
- 9: = conductive thin-film layer

## Claims

1. A thin-film photoelectric conversion device being subjected to annealing of a silicon substrate on which a first metal thin-film layer made of a first metal and a second metal thin-film layer made of a second metal are laminated such that the second metal thin-film layer overlaps with a part of the first metal thin-film layer,
the thin-film photoelectric conversion device comprising:
- a metal silicide layer formed on a surface of the silicon substrate by diffusion of the first metal and silicon;
- a conductive thin-film layer formed on the surface of the silicon substrate in a region where the second metal thin-film layer is laminated; and
- a silicon diffused portion formed between the metal silicide layer and the conductive thin-film layer near the surface of the silicon substrate by diffusion of silicon nano-particles,
- wherein light is irradiated to the metal silicide layer or the conductive thin-film layer each forming a Schottky interface in a direction in which the metal silicide layer or the conductive thin-film layer is laminated on the silicon substrate, thereby generating a photo-induced current between the metal silicide layer and the conductive thin-film layer on the surface of the silicon substrate.

2. The thin-film photoelectric conversion device according to Claim 1,
wherein the conductive thin-film layer has a thickness of smaller than 100 nm and the metal silicide layer has a smaller thickness than the conductive thin-film layer.

3. The thin-film photoelectric conversion device according to Claim 1 or 2,
wherein the first metal is any of Co, Fe, W, Ni, Al and Ti, and the second metal is Au.

4. A method of manufacturing a thin-film photoelectric conversion device, the method comprising:
- a first step of forming a first metal thin-film layer made of a first metal on a silicon substrate;
- a second step of forming a second metal thin-film layer made of a second metal on a part of the first metal thin-film layer; and
- a third step of annealing the first metal thin-film layer and the second metal thin-film layer which are laminated on the silicon substrate, to thereby form a metal silicide layer on the substrate, the metal silicide layer containing the first metal and silicon diffused therein, a conductive thin-film layer in a region where the second metal thin-film layer is laminated, and a silicon diffused portion between the metal silicide layer and the conductive thin-film layer near the surface of the silicon substrate, the conductive thin-film layer containing silicon nano-particles diffused therein,
- wherein light is irradiated to the metal silicide layer or the conductive thin-film layer each forming a Schottky interface in a direction in which the metal silicide layer or the conductive thin-film layer is laminated on the silicon substrate, thereby generating a photo-induced current between the metal silicide layer and the conductive thin-film layer on the surface of the silicon substrate.

5. The method of manufacturing the thin-film photoelectric conversion device according to Claim 4,
wherein the conductive thin-film layer has a thickness of smaller than 100 nm and the metal silicide layer has a smaller thickness than the conductive thin-film layer.

6. The method of manufacturing the thin-film photoelectric conversion device according to Claim 4 or 5,
wherein the first metal is any of Co, Fe, W, Ni, Al and Ti, and the second metal is Au.
